Europäisches Patentamt

European Patent Office

Office européen des brevets

(11) Numéro de publication : **0 398 824 B1**

# FASCICULE DE BREVET EUROPEEN

(45) Date de publication du fascicule du brevet :
**28.12.94 Bulletin 94/52**

(51) Int. Cl.$^5$ : **G01R 31/02, G01R 27/18**

(21) Numéro de dépôt : **90420225.6**

(22) Date de dépôt : **15.05.90**

(54) Contrôleur d'isolement numérique pour réseau électrique.

(30) Priorité : **19.05.89 FR 8906690**

(43) Date de publication de la demande :
**22.11.90 Bulletin 90/47**

(45) Mention de la délivrance du brevet :
**28.12.94 Bulletin 94/52**

(84) Etats contractants désignés :
**BE CH DE ES GB IT LI SE**

(56) Documents cités :
**EP-A- 0 297 933**
**DE-A- 2 826 517**
**PATENT ABSTRACTS OF JAPAN, vol. 12, no. 394 (P-773)[3241], 20 octobre 1988; & JP-A-63 135 876 (FURUKAWA ELECTRIC CO., LTD:THE) 08-06-1988**
**TECHNISCHES MESSEN T.M., vol. 53, no. 6, 1986, pages 220-228, Munich, DE; H. SCHOLL-MEYER: "Digitale Brückenschaltungen für passive Sensoren zur Impedanz-Frequenz-Umsetzung"**

(73) Titulaire : **MERLIN GERIN**
**2, chemin des Sources**
**F-38240 Meylan (FR)**

(72) Inventeur : **Bouchez, Bruno**
**Merlin Gerin- Sce. Brevets**
**F-38050 Grenoble Cedex (FR)**
Inventeur : **Barjonnet, Jean-Paul**
**Merlin Gerin- Sce. Brevets**
**F-38050 Grenoble Cedex (FR)**
Inventeur : **Le Maitre, Philippe**
**Merlin Gerin- Sce. Brevets**
**F-38050 Grenoble Cedex (FR)**

(74) Mandataire : **Hecke, Gérard et al**
**Merlin Gérin,**
**Sce. Propriété Industrielle**
**F-38050 Grenoble Cédex 9 (FR)**

## Description

L'invention est relative à un contrôleur d'isolement comprenant:
- un circuit d'injection d'un signal alternatif de référence entre le réseau et la terre,
- un circuit électronique de détection fournissant un signal de mesure image de l'isolement du réseau, ledit isolement correspondant à une impédance Zd formée par une résistance de fuite Rf connectée électriquement en parallèle sur un condensateur Cf parasite, dont la capacité dépend des caractéristiques du réseau,
- des moyens de discrimination des composantes résistive et capacitive du signal de mesure,
- et des moyens de calcul et de signalisation des modules desdites composantes pour visualiser les valeurs de la résistance de fuite Rf et du condensateur Cf parasite sur des moyens d'affichage et d'alarme.

Le document FR-A 2.616.228 fait connaître un contrôleur d'isolement renfermant un générateur qui injecte une tension alternative de référence à basse fréquence dans un réseau, et un détecteur synchrone analogique ayant une paire d'inverseurs statiques de traitement des composantes résistive et capacitive du signal de mesure proportionnel à l'impédance d'isolement. Un convertisseur est connecté au générateur pour délivrer deux signaux de commande en quadrature pour piloter les inverseurs, l'un des signaux de commande étant en phase avec le signal alternatif de référence injecté sur le réseau par un générateur. La précision du contrôleur dépend de la stabilité en phase de la chaîne de mesure. L'emploi d'un générateur avec un détecteur synchrone analogique risque de faire varier le taux de distorsion en phase selon les caractéristiques des composants électroniques, ce qui introduit des erreurs de mesure.

L'objet de l'invention consiste à améliorer la précision de mesure d'un contrôleur d'isolement.

Le contrôleur d'isolement selon l'invention est caractérisé en ce que le contrôleur d'isolement comporte: un processeur P1 de signal à traitement numérique destiné à synthétiser en temps réel une sinusoïde par table stockée dans une mémoire, et à envoyer les valeurs numériques de cette sinusoïde dans un convertisseur CNA numérique/analogique d'une chaîne d'injection pour générer le signal alternatif de référence,
- une chaîne d'acquisition ayant un filtre analogique passe-bas connecté par l'intermédiaire d'un circuit échantillonneur bloqueur à un convertisseur CAN analogique/numérique délivrant un signal de mesure numérique filtré qui est traité par démodulation synchrone dans ledit processeur P1, puis transmis vers un microcontrôleur P2,
- un double circuit de mesure de ladite chaîne d'acquisition comprenant un premier circuit de mesure délivrant un premier signal S1 représentant la tension injectée sur le réseau, et un deuxième circuit de mesure fournissant un deuxième signal S2 fonction du courant de fuite circulant dans l'impédance Zd,
- et un moyen de commutation piloté par le processeur P1 pour injecter dans la chaîne d'acquisition le premier ou le deuxième signal.

La fréquence du signal alternatif de référence injecté dans le réseau par la chaîne d'injection est un sous-multiple de la fréquence du réseau. Le processeur P1 synthétise la sinusoïde par points en utilisant la formule:
$$\text{sinus } (A + b) = \sin A \cos b + \sin b . \cos A,$$
dans laquelle le premier paramètre A varie de 0 à 90 degrés par pas déterminés m1 égal à 90/n, et le deuxième paramètre b varie de 0 à m1 degrés par pas prédéterminés m2 égal à m1/n.

La génération numérique par le processeur du signal alternatif de référence permet d'obtenir un taux de distorsion en phase très faible et stable. La chaîne de mesure introduit alors un minimum d'erreur de phase dans le processeur pour le traitement par démodulation synchrone. Cette stabilité en phase favorise la précision du contrôleur.

La chaîne d'acquisition coopère avec un double circuit de mesure délivrant un premier signal S1 et un deuxième signal S2 représentant respectivement la tension injectée sur le réseau, et le courant de fuite circulant dans l'impédance Zd, et est dotée d'un commutateur formé par un multiplexeur analogique destiné à prendre en compte alternativement le premier signal S1 en provenance d'un pont résistif R1-R2 du premier circuit de mesure connecté au réseau, et le deuxième signal S2 prélevé aux bornes d'une résistance de mesure R3 du deuxième circuit de mesure relié à la terre, la commande de basculement du commutateur étant pilotée par le processeur P1 de signal.

Après filtrage numérique et traitement par démodulation synchrone, le processeur transmet les données à un microcontrôleur qui calcule en temps différé les valeurs de la résistance de fuite, du condensateur parasite, et de la résistance de terre.

Le microcontrôleur P2 est associé à :
- un clavier à touches de commande pour l'entrée des données et le défilement de l'affichage,
- un premier afficheur alphanumérique pour l'affichage des valeurs de la résistance de fuite Rf, du condensateur Cf parasite, et de la résistance de terre Rt,
- un deuxième afficheur à bar-graph pour indiquer en continu le niveau d'isolement par rapport à des

2

seuils d'alarme et de préalarme,
- un dispositif d'alarme à relais de signalisation alimentés en cas de franchissement desdits seuils,
- et un interface de communication avec un bus pour transmettre ou recevoir des données d'un dispositif émetteur/récepteur extérieur.

Un plombage numérique à code secret est programmé à l'intérieur du microcontrôleur P2, et la modification de paramètres n'est autorisée par le clavier que si le code entré est conforme.

D'autres avantages et caractéristiques ressortiront plus clairement de la description qui va suivre d'un mode de réalisation de l'invention, donnée à titre d'exemple non limitatif, et représenté au dessin annexé, dans lequel:
- la figure 1 est un schéma synoptique du contrôleur d'isolement numérique selon l'invention;
- la figure 2 est une vue partielle de la fig. 1, représentant le schéma équivalent du filtre d'injection et du double circuit de mesure.

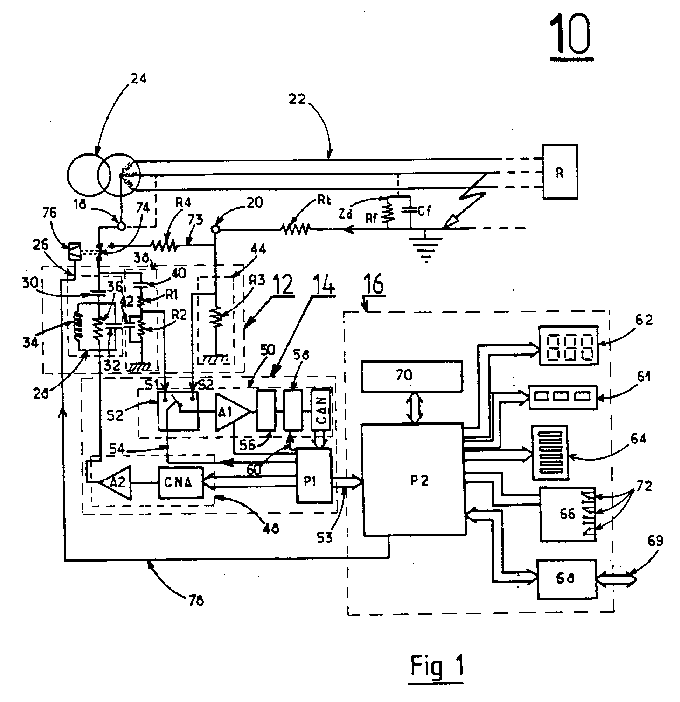

Sur la figure 1, un contrôleur d'isolement 10 numérique est formé par l'association de trois blocs fonctionnels 12, 14, 16 agencés pour constituer un circuit d'injection d'un signal alternatif de référence à basse fréquence entre le réseau et la terre, et un circuit de détection et de traitement fournissant un signal image de l'isolement du réseau. Le contrôleur est muni de deux bornes de raccordement 18, 20, dont l'une 18 est connectée au réseau 22, et dont l'autre se trouve au potentiel de la terre.

Le réseau 22 représenté sur la figure 1, est un réseau alternatif triphasé à neutre isolé (régime du neutre IT), mais il est clair que la configuration du réseau peut être différente (régime de neutre TN ou TT). Dans le cas du régime IT de la figure 1, la borne 18 d'injection est reliée soit au neutre du transformateur de puissance 24 moyenne tension/basse tension, soit directement à l'un des conducteurs de phase (connexion en pointillé). Le réseau 22 alimente au moins un récepteur R disposé à l'opposé du transformateur de puissance. La fréquence du réseau alternatif est de 50 Hz, 60 Hz ou 400 Hz selon la nature ou le pays de l'installation électrique.

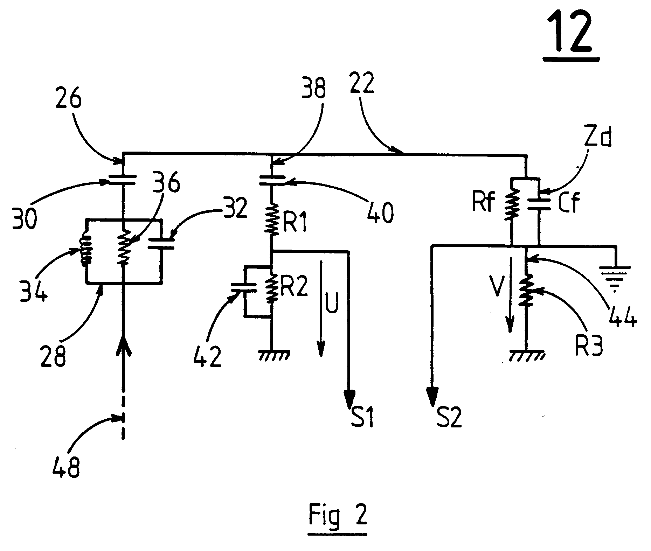

Le premier bloc fonctionnel 12 (voir figures 1 et 2) est composé d'un filtre d'injection 26 ayant un circuit bouchon 28 accordé sur la fréquence d'un réseau. Un condensateur de tête 30 inséré entre le circuit bouchon 28 et la borne 18 est destiné à couper la composante continue du réseau 22 alternatif, ou à couper le courant continu dans le cas d'utilisation sur un réseau continu. Le circuit bouchon 28 est constitué par la mise en parallèle d'un condensateur 32, d'une self 34 et d'une résistance 36, la fonction de cette dernière étant d'éviter le phénomène de ferro-résonance.

Pour calculer le niveau d'isolement du réseau, il est nécessaire de connaître la valeur de la tension injectée, ainsi que le courant circulant dans l'impédance de défaut Zd entre le réseau et la terre.

Au filtre d'injection 26 est branché en parallèle du côté réseau un premier circuit de mesure 38 de tension comprenant un pont résistif (R1-R2) pour la mesure de la tension injectée. Un condensateur 40 série permet de couper la composante continue du réseau 22, et un condensateur 42 en parallèle sur la résistance R2 atténue la composante alternative du réseau. La résistance R2 est connectée à la masse, et l'image de la tension injectée est prélevée au point d'interconnexion des résistances du pont résistif R1-R2.

Une résistance de mesure R3 d'un deuxième circuit de mesure 44 de tension est branchée entre la borne 20 et la masse, de manière à se trouver en série avec l'impédance de défaut Zd du réseau. La tension V prélevée aux bornes de la résistance R3 est proportionnelle au courant de fuite Id circulant dans l'impédance de défaut Zd.

De la double mesure des signaux de sortie S1 et S2 des premier et deuxième circuits de mesure 38,44 de tension du premier bloc 12 découle le principe de calcul du niveau d'isolement :

Si la tension U mesurée aux bornes de la résistance R2 est l'image de la tension injectée, la tension U1 réelle injectée sur ce réseau est donnée approximativement par la relation :

$$(1) \qquad U1 = U (R1 + R2/R2)$$

en négligeant les impédances des condensateurs 40, 42.

D'autre part, si V est la tension mesurée aux bornes de la résistance R3, le courant Id circulant dans le défaut est donné par la relation :

$$(2) \qquad Id = V/R3$$

La tension U2 aux bornes de l'impédance de défaut Zd a pour valeur U2 = U1-V. L'impédance de défaut Zd est représentée par la relation :

$$(3) \qquad Zd = U2/Id$$
$$= (U1-V)/Id$$
$$= (U1-V).R3/V$$

$$(4) \qquad Zd = R3/V \left[ U\ (R1+R2)/R2 - V \right]$$

On remarque que l'impédance de défaut Zd dépend des valeurs des résistances R1, R2, R3 des deux circuits de mesure 38, 44, et des valeurs des tensions U et V qui sont proportionnelles respectivement à la tension injectée sur le réseau, et au courant de fuite Id circulant dans l'impédance de défaut Zd.

Toutes ces valeurs étant connues par construction et par mesure, la détermination de l'impédance de défaut Zd est possible, sans faire intervenir les caractéristiques du filtre d'injection 26. Le procédé de double mesure des tensions U et V pour le calcul de l'impédance Zd, permet alors de s'affranchir des tolérances de fabrication des composants, notamment de la self 34 et des condensateurs 30, 32 du filtre d'injection 26.

Le deuxième bloc fonctionnel 14 (fig. 1) comporte un processeur de signal P1 associé à:
- une chaîne d'injection 48 connectée au circuit bouchon 28;
- une chaîne d'acquisition 50 des signaux de sorties S1 et S2 des premier et deuxième circuits de mesure 38, 44 représentant respectivement les valeurs de la tension injectée sur le réseau, et du courant de défaut dans l'impédance Zd;
- une liaison 53 de communication avec un microcontrôleur P2.

Le processeur de signal P1 est un microprocesseur numérique spécifique très rapide qui permet des multiplications et des divisions de nombres de 16 bits en une instruction.

La chaîne d'acquisition 50 comporte un commutateur 52 formé par un multiplexeur analogique CMOS destiné à prendre en compte alternativement le premier signal S1 et le deuxième signal S2 du bloc 12. La commande de commutation est générée par le processeur P1, et envoyée au commutateur 52 par un conducteur de liaison 54. La sortie du commutateur 52 est reliée à un premier amplificateur A1 à gain variable, qui amplifie le signal S1 ou le signal S2. Le signal obtenu passe ensuite dans un filtre analogique 56 passe-bas destiné à éviter le repliement du spectre lors de la numérisation. Le signal filtré est envoyé dans un circuit échantillonneur-bloqueur 58, puis est converti au moyen d'un convertisseur analogique/numérique CAN. Le circuit échantillonneur-bloqueur 58 est commandé par des signaux d'horloge générés par le processeur P1, et véhiculés par un conducteur de liaison 60. Les données numérisées sont envoyées au processeur de signal P1 qui effectue la démodulation synchrone, et règle le gain de l'amplificateur A1.

La chaîne d'injection 48 comporte un convertisseur numérique/analogique CNA raccordé au processeur de signal P1, et un deuxième amplificateur A2 inséré entre le convertisseur CNA et le circuit bouchon 28. La chaîne d'injection 48 du deuxième bloc 14 utilise une partie des ressources du processeur de signal P1 pour synthétiser numériquement en temps réel le signal sinusoïdal injecté à basse fréquence.

Le processeur P1 génère le signal sinusoïdal injecté sur 1024 points. Etant donné qu'il s'agit d'un composant numérique, la génération de la sinusoïde est effectuée par calcul en utilisant la formule suivante :

$$\text{sinus}\ (A + b) = \text{sinus}\ (A)\cos(b) + \sin(b)\cos(A)$$

Pour cela, on utilise A comme paramètre "gros":A varie de 0 à 90 degrés par pas de 90/16 = 5.625 degrés. b est utilisé comme paramètre "fin":b varie de 0 à 5,625 degrés par pas de 5,625/16 = 0,351 degré.

Quatre tables de 16 données chacune sont stockées dans une mémoire du processeur P1 :
- une table de sinus (A)
- une table de cosinus (A)
- une table de sinus (b)
- une table de cosinus (b)

Pour générer une sinusoïde, on commence par faire A = 0 et on fait varier b de 0 à 5,625, puis A = 5,625 et on fait varier b de 0 à 5,625 puis A = 11,25 et b varie de 0 à 5,625 etc. La génération de 0 à 90 degrés de la sinusoïde est donc faite de 256 points.

Au-delà de 90 degrés, il suffit de parcourir les tables en sens inverse pour obtenir la décroissance de la sinusoïde. Quand on dépasse 180 degrés, il suffit d'inverser le signe du résultat en suivant la même méthode (avec changement de sens de lecture de table à 270 degrés).

On remarque que seul le quart d'une sinusoïde se trouve en mémoire. Il en résulte un gain de place mémoire dans le processeur P1.

Le traitement par démodulation synchrone dans le processeur P1 nécessite aussi de connaître le cosinus du signal injecté. On utilise le même principe sachant que:

$$\text{cosinus}\ (A + b) = \cos(A)\cos(b) - \sin(b)\sin(A)$$

On utilise les mêmes tables.

Les valeurs numériques de la sinusoïde ainsi obtenue sont envoyées vers le convertisseur numérique/analogique CNA qui les transforme en une tension analogique. On utilise la fonction sinus car elle commence à 0 à t = 0. L'amplificateur A2 fournit le courant nécessaire à l'injection sur le réseau, après passage dans le filtre d'injection 28. La fréquence du signal alternatif d'injection est un sous-multiple de la fréquence du réseau, tel que décrit en détail par la suite.

Après l'élimination préalable par le filtre 56 passe-bas des signaux parasites HF et du bruit notamment de fréquences supérieures à 100 Hz, qui pourraient être ramenés dans la bande utile de la fréquence d'injection après échantillonnage, le processeur de signal P1 effectue un premier filtrage numérique consistant à couper le spectre à 264 Hz puis décime les échantillons en prenant un échantillon sur huit. Cela revient à échantillonner à une fréquence huit fois plus faible. Le processeur P1 effectue ensuite un filtrage numérique, éliminant la fréquence de 50 Hz sur les signaux numérisés images de la tension injectée et du courant de fuite. Le procédé de filtrage numérique consiste à couper le spectre à 12 Hz, en donnant une réjection de 60 dB au moins à 50 Hz. La structure des filtres numériques est par exemple de type TSCHEBYTCHEV récursif.

Le processeur de signal P1 effectue ensuite la démodulation synchrone, dont le procédé consiste à multiplier le signal numérique filtré par le sinus du déphasage, puis à l'intégrer pour obtenir la partie réelle du signal de sortie S1 ou S2. La partie imaginaire de ce signal S1 ou S2 est obtenue d'une manière similaire en multipliant le signal numérique filtré par le cosinus, suivi de l'intégration.

La démodulation synchrone a pour particularité de rejeter toutes les fréquences harmoniques de la fréquence du signal d'injection. Pour cette raison, la fréquence d'injection sera un sous-multiple de 50 Hz, notamment 10, 5, 2,5 ou 1 Hz. Pour améliorer la précision de mesure, il faut travailler à fréquence basse. Selon le cas, le processeur P1 travaillera à 10 hertz (réseaux peu capacitifs), à 5 hertz (réseaux capacitifs) ou à 2,5 et même 1 hertz pour les réseaux très capacitifs.

La génération numérique du signal d'injection par la chaîne d'injection 48 procure un taux de distorsion en phase très faible et très stable. Cette caractéristique profite avantageusement au principe de démodulation synchrone mis en oeuvre dans le processeur P1 et qui nécessite un minimum d'erreur de phase dans la chaîne d'acquisition 50.

On remarque d'autre part que la résistance de terre Rt (montrée en pointillé sur la figure 1), insérée électriquement entre l'impédance de défaut Zd et la borne 20 du contrôleur d'isolement 10, affecte la précision de la mesure d'isolement, car la résistance de terre Rt se trouve en série avec la résistance de fuite Rf. Un fonctionnement intermittent à deux fréquences différentes, par exemple 10 Hz et 5 Hz du processeur de signal P1 permettra de calculer la valeur de la résistance de terre Rt dans le microcontrôleur P2.

La commande de gain de l'amplificateur A1 de la chaîne d'acquisition 50 s'opère de la manière suivante :

Le processeur de signal P1 calcule le carré du module du signal numérique filtré S1 ou S2 correspondant à la tension injectée et au courant d'isolement. Si ce module dépasse Vmax/2 (Vmax étant par exemple égal à 10 volt), il y a risque de saturation au niveau de l'amplificateur A1. Le processeur P1 règle alors le gain de l'amplificateur au gain immédiatement inférieur. Si ce module est inférieur à Vmax/4, le processeur P1 règle le gain de l'amplificateur A1 au gain immédiatement supérieur. Il en résulte que le signal reçu par le processeur P1 a toujours la dynamique maximale.

A la fin de chaque séquence de mesure correspondant à un réglage d'amplitude, un temps de stabilisation du filtre numérique, et un temps de mesure, le processeur P1 envoie vers le microcontrôleur P2 quatre types de mesure pour chaque fréquence de travail 10 Hz et 5 Hz :

- partie réelle du signal de courant et le gain associé
- partie imaginaire du signal du courant
- partie réelle du signal de tension et le gain associé
- partie imaginaire du signal de tension.

Dans le troisième bloc fonctionnel 16, le microcontrôleur P2 utilise les données transmises par le processeur de signal P1 pour calculer les valeurs de la résistance d'isolement Rf, la capacité Cf du réseau et la résistance de terre Rt. Il gère un clavier 61, les affichages 62, 64, les commandes d'un dispositif d'alarme 66 et un interface de communication 68 avec un bus 69 de transmission de données. Le microcontrôleur P2 permet, grâce à une alimentation sauvegardée de la zone mémoire 70 de mémoriser des défauts en particulier fugitifs et de sauvegarder la configuration de l'appareil en cas de coupure d'alimentation. Le microcontrôleur P2 utilise la relation (4) précédente pour le calcul des valeurs Rf, Cf et Rt. Le microcontrôleur P2 travaille en léger différé et est moins rapide que le processeur de signal P1 qui travaille en temps réel à chaque arrivée d'échantillons. Les affichages gérés par le microcontrôleur P2 comportent :

- un afficheur alphanumérique 62
- un afficheur du type bar-graph 64

L'affichage alphanumérique donne en clair les valeurs de la résistance d'isolement Rf, de la capacité du réseau Cf, et de la résistance de terre Rt. L'afficheur 62 permet l'affichage d'un "menu" proposant la lecture de paramètres, la programmation de paramètres, le lancement du mode test ou l'acquittement des alarmes. L'affichage des données sur l'afficheur 62 peut s'effectuer en différentes langues grâce à une programmation prédéterminée.

L'affichage bar-graph 64 indique en continu le niveau d'isolement par rapport à un seuil d'alarme et un seuil de pré-alarme. Une coloration verte indique un isolement supérieur au seuil de pré-alarme (seuil d'isolement haut), et une coloration jaune indique un isolement inférieur au seuil de pré-alarme, mais supérieur au seuil d'alarme. Une coloration rouge indique un isolement inférieur aux seuils de pré-alarme et d'alarme. Le segment allumé situe l'isolement par rapport aux seuils.

Le clavier 61 comporte un nombre limité de touches non spécifiques : la ligne inférieure de l'écran alphanumérique de l'afficheur 62 définit la fonction de chacune des touches. Le clavier 61 permet l'entrée des données (seuils), le défilement de l'affichage, et un mode test.

Le dispositif d'alarme 66 comporte des relais 72 commandés lors du franchissement des seuils. Un des relais 72 est commandé au franchissement du seuil de pré-alarme, et deux autres relais 72 sont commandés au franchissement du seuil d'alarme.

L'interface de communication 68 avec le bus 69 permet de transmettre ou de recevoir des données d'un dispositif émetteur/récepteur extérieur. Les données émises peuvent être la valeur de la résistance d'isolement, la capacité de ligne, la valeur des défauts fugitifs, etc. Les données reçues sont des modifications de valeurs de seuils, des demandes d'envoi d'informations, etc.

Un dispositif de test du contrôleur 10 comporte un circuit d'essai 73 ayant une résistance de test R4 dont l'une des extrémités est branchée à la borne 20, et dont l'autre extrémité peut coopérer avec un contact 74 bistable d'un relais 76 de commande. Lorsque le relais 76 n'est pas excité, le contact 74 ouvre le circuit d'essai 73, mais ferme le circuit du filtre d'injection 26, en autorisant l'injection vers le réseau du signal sinusoïdal BF élaboré par le processeur de signal P1.

Le mode test s'opère en appuyant sur la touche test du clavier 61 entrainant l'émission par le conducteur 78 du microcontrôleur P2 d'un ordre d'excitation du relais 76. Le contact 74 est alors commuté vers la position représentée en pointillé, de manière à fermer le circuit d'essai 73, et à interdire l'injection du signal sinusoïdal BF sur le réseau. L'insertion de la résistance de test R4 simule un défaut d'isolement apparaissant à l'entrée du contrôleur 10 entre les bornes 18, 20. Ce défaut est pris en compte par la chaîne d'acquisition 50, et le processeur de signal P1, et est ensuite affiché sur l'écran de l'afficheur 62 par le contrôleur P2.

Un plombage numérique à code secret est programmé à l'intérieur du microcontrôleur P2, et une touche de code est accessible sur le clavier 61 pour autoriser l'entrée de nouveaux paramètres en cas de conformité du code.

## Revendications

1. Contrôleur d'isolement comprenant :
   - un circuit d'injection d'un signal alternatif de référence entre le réseau et la terre,
   - un circuit électronique de détection fournissant un signal de mesure image de l'isolement du réseau, ledit isolement correspondant à une impédance Zd formée par une résistance de fuite Rf connectée électriquement en parallèle sur un condensateur Cf parasite, dont la capacité dépend des caractéristiques du réseau,
   - des moyens de discrimination des composantes résistive et capacitive du signal de mesure,
   - et des moyens de calcul et de signalisation des modules desdites composantes pour visualiser les valeurs de la résistance de fuite Rf et du condensateur Cf parasite sur des moyens d'affichage et d'alarme,
   
   caractérisé en ce que le contrôleur d'isolement (10) comporte:
   
   un processeur P1 de signal à traitement numérique destiné à synthétiser en temps réel une sinusoïde par table stockée dans une mémoire, et à envoyer les valeurs numériques de cette sinusoïde dans un convertisseur CNA numérique/analogique d'une chaîne d'injection (48) pour générer le signal alternatif de référence,
   - une chaîne d'acquisition (50) ayant un filtre analogique (56) passe-bas connecté par l'intermédiaire d'un circuit échantillonneur bloqueur (58) à un convertisseur CAN analogique/numérique délivrant un signal de mesure numérique filtré qui est traité par démodulation synchrone dans ledit processeur P1, puis transmis vers un microcontrôleur P2,
   - un double circuit de mesure de ladite chaîne d'acquisition comprenant un premier circuit de mesure (38) délivrant un premier signal S1 représentant la tension injectée sur le réseau, et un deuxième circuit de mesure (44) fournissant un deuxième signal S2 fonction du courant de fuite circulant dans l'impédance Zd,
   - et un moyen de commutation (52) piloté par le processeur P1 pour injecter dans la chaîne d'acquisition (50) le premier ou le deuxième signal.

2. Contrôleur d'isolement selon la revendication 1, caractérisé en ce que la fréquence du signal alternatif de référence injecté dans le réseau par la chaîne d'injection (48) est un sous-multiple de la fréquence du réseau, et que le processeur P1 synthétise la sinusoïde par points en utilisant la formule :

$$sinus\ (A + b)\ =\ sin\ A\ cos\ b\ +\ sin\ b.cos\ A,$$

dans laquelle le premier paramètre A varie de 0 à 90 degrés par pas prédéterminés m1 égal à 90/n, et le deuxième paramètre b varie de 0 à m1 degrés par pas prédéterminés m2 égal à m1/n.

3. Contrôleur d'isolement selon la revendication 1 ou 2, caractérisé en ce que la sortie du convertisseur CNA numérique/analogique est branché par l'intermédiaire d'un premier amplificateur A2 à un filtre d'injection (26) à circuit bouchon (28) accordé sur la fréquence du réseau.

4. Contrôleur d'isolement selon la revendication 3,caractérisé en ce que le moyen de commutation (52) est formé par un multiplexeur analogique destiné à prendre en compte alternativement le premier signal S1 en provenance d'un pont résistif R1-R2 du premier circuit de mesure (38) connecté au réseau, et le deuxième signal S2 prélevé aux bornes d'une résistance de mesure R3 du deuxième circuit de mesure (44) relié à la terre, la commande de basculement du moyen de commutation (52) étant reliée au processeur P1 de signal.

5. Contrôleur d'isolement selon la revendication 4, caractérisé en ce qu'un deuxième amplificateur A1 à gain variable est inséré entre le multiplexeur du moyen de commutation (52) et le filtre analogique (56) pour amplifier lesdits premier et deuxième signaux S1 et S2, le réglage du gain du deuxième amplificateur A1 étant opéré par le processeur P1 en fonction de la valeur du module du signal numérique filtré à la sortie du convertisseur CAN analogique/numérique.

6. Contrôleur d'isolement selon la revendication 5, caractérisé en ce que le processeur P1 effectue un filtrage numérique éliminant les fréquences parasites dans les signaux numérisés images de la tension injectée et du courant de fuite, suivi du traitement par démodulation synchrone consistant à multiplier lesdits signaux numérisés par le sinus et le cosinus du déphasage, et qu'à la fin de chaque séquence de mesure et d'intégration, le processeur P1 envoie par l'intermédiaire d'une liaison (53), des données vers le microcontrôleur P2 concernant les parties réelles et imaginaires des signaux de tension injectée et de courant de fuite.

7. Contrôleur d'isolement selon la revendication 6, caractérisé en ce que le microcontrôleur P2 calcule en temps différé les valeurs de la résistance de fuite Rf, du condensateur Cf parasite, et de la résistance de terre Rt située entre l'impédance Zd et la résistance de mesure R3, suite à un fonctionnement intermittent à deux fréquences différentes du processeur P1.

8. Contrôleur d'isolement selon la revendication 7, caractérisé en ce que le microcontrôleur P2 est associé à:
   - un clavier (61) à touches de commande pour l'entrée des données et le défilement de l'affichage,
   - un premier afficheur (62) alphanumérique pour l'affichage des valeurs de la résistance de fuite Rf, du condensateur Cf parasite, et de la résistance de terre Rt,
   - un deuxième afficheur (64) à bar-graph pour indiquer en continu le niveau d'isolement par rapport à des seuils d'alarme et de pré-alarme,
   - un dispositif d'alarme (66) à relais de signalisation alimentés en cas de franchissement desdits seuils,
   - et un interface de communication (68) avec un bus (69) pour transmettre ou recevoir des données d'un dispositif émetteur/récepteur extérieur.

9. Contrôleur d'isolement selon la revendication 8,caractérisé en ce qu'un plombage numérique à code secret est programmé à l'intérieur du microcontrôleur P2, et qu'une touche de code est accessible sur le clavier (61) pour autoriser la modification de paramètres en cas de conformité de code.

10. Contrôleur d'isolement selon la revendication 8 ou 9, caractérisé en ce que le clavier (61) comporte une touche test destinée à envoyer par l'intermédiaire du microcontrôleur P2 un ordre d'excitation à un relais (76) de commande agencé pour assurer la mise en circuit d'une résistance test R4, et la déconnexion du filtre d'injection (26) avec le réseau.

**Patentansprüche**

1.  Isolationswächter, bestehend aus:
    - einem Treiberkreis, der ein Wechselspannungs-Referenzsignal zwischen Netz und Erde injiziert,
    - einer elektronischen Erfassungsschaltung, die ein den Isolationszustand des Netzes abbildendes Meßsignal liefert, wobei der genannte Isolationszustand einer Impedanz Zd entspricht, die sich aus einem Ableitwiderstand Rf und einem parallel dazu liegenden Störkondensator Cf zusammensetzt, dessen Kapazität von den Netzparametern abhängt,
    - Mitteln zur Trennung des ohmschen und kapazitiven Anteils des Meßsignals
    - sowie Mitteln zur Berechnung und Anzeige der Beträge der genannten Anteile, um die Werte Für den Ableitwiderstand Rf sowie den Störkondensator Cf mit Hilfe Anzeige- und Alarmmitteln darzustellen, dadurch gekennzeichnet, daß der Isolationswächter (10) folgende Baugruppen umfaßt:
    - einen digitalen Signalprozessor P1, der in Echtzeit über eine in einem Speicher abgelegte Tabelle eine Sinusspannung erzeugt, und zum Zwecke der Erzeugung des Wechselspannungs-Referenzsignals einen Digital-Analog-Umsetzers CNA eines Treiberkreises (48) mit den digitalen Werten dieser Sinusspannung beaufschlagt,
    - eine Signalerfassungsschaltung (50) mit einem Analog-Tiefpaß (56), der über eine Abtast-Blockier-Schaltung (58) mit einem Analog-Digital-Umsetzers CAN zur Lieferung eines gefilterten digitalen Meßsignals verbunden ist, das im genannten Prozessor P1 durch SynchronDemodulation weiterverarbeitet und dann an eine Mikroprozessorsteuerung P2 übertragen wird,
    - einen doppelten Meßkreis der genannten Signalerfassungsschaltung mit einem ersten Meßkreis (38) zur Lieferung eines ersten der über das Netz getriebenen Spannung entsprechenden Signals S1 und einem zweiten Meßkreis (44) zur Lieferung eines zweiten Signals S2 in Funktion des in der Impedanz Zd fließenden Erdfehlerstroms
    - und ein durch den Prozessor P1 angesteuertes Schaltorgan (52) zur Injizierung des ersten bzw. des zweiten Signals in die Signalerfassungsschaltung (50).

2.  Isolationswächter nach Anspruch 1, dadurch gekennzeichnet, daß die Frequenz des durch den Treiberkreis ins Netz injizierten Wechselspannungs-Referenzsignals ein Teiler der Netzfrequenz ist und daß der Prozessor P1 die Sinusspannung schrittweise entsprechend folgender Formel erzeugt:

    $$\text{sinus} (A + b) = \sin A \cos b + \sin b \cdot \cos A,$$

    wobei der erste Parameter A in m1 entsprechend 90/n festgelegten Schritten zwischen 0 und 90 Grad und der zweite Parameter b in m2 entsprechend m1/n festgelegten Schritten zwischen 0 und m1 Grad variiert.

3.  Isolationswächter nach Anspruch 1 oder 2, dadurch gekennzeichnet, daß der Ausgang des Digital-Analog-Umsetzers CNA über einen ersten Verstärker A2 an ein Treiberfilter (26) mit einem auf Netzfrequenz abgestimmten Sperrkreis (28) angeschlossen ist.

4.  Isolationswächter nach Anspruch 3, dadurch gekennzeichnet, daß das Schaltorgan (52) aus einem Analog-Multiplexer zur abwechselnden Weiterleitung des von einer Widerstandsbrücke R1-R2 des ersten, mit dem Netz verbundenen Meßkreises (38) gelieferten ersten Signals S1 und des an den Klemmen eines Meßwiderstands R3 des zweiten, mit Erde verbundenen Meßkreises (44) abgegriffenen zweiten Signals S2 besteht, wobei der Steuereingang des Schaltorgans (52) mit dem Signalprozessor P1 verbunden ist.

5.  Isolationswächter nach Anspruch 4, dadurch gekennzeichnet, daß zur Verstärkung des genannten ersten bzw. zweiten Signals S1 bzw. S2 ein zweiter Verstärker A1 mit verstellbarem Verstärkungsfaktor zwischen den Multiplexer des Schaltorgans (52) und das Analogfilter (56) geschaltet ist, wobei die Regelung des Verstärkungsfaktors des zweiten Verstärkers A1 durch den Prozessor P1 in Abhängigkeit vom Wert des Betrags des gefilterten Digitalsignals am Ausgang des Analog-Digital-Umsetzers CAN erfolgt.

6.  Isolationswächter nach Anspruch 5, dadurch gekennzeichnet, daß im Prozessor P1 zuerst eine Digitalfilterung zur Unterdrückung der Störfrequenzen in den digitalisierten, die injizierte Spannung bzw. den Erdfehlerstrom abbildenden Signalen und danach die Synchron-Demodulation durch Multiplikation der genannten Digitalsignale mit dem Sinus und dem Kosinus des Phasenverschiebungswinkels erfolgt, und daß der Prozessor P1 am Ende jeder Meß- und Integrationssequenz Daten über die Wirk- und Blindanteile der injizierten Spannung bzw. des Erdfehlerstroms über eine Verbindung (53) an die Mikroprozessorsteuerung P2 weiterleitet.

7. Isolationswächter nach Anspruch 6, dadurch gekennzeichnet, daß die Mikroprozessorsteuerung P2 zeitversetzt die Werte des Ableitwiderstands Rf, des Störkondensators Cf und, nach abwechselndem Betrieb des Prozessors P1 bei zwei verschiedenen Frequenzen, des zwischen der Impedanz Zd und dem Meßwiderstand R3 liegenden Erdwiderstands Rt berechnet.

8. Isolationswächter nach Anspruch 7, dadurch gekennzeichnet, daß die Mikroprozessorsteuerung P2 folgenden Baugruppen zugeordnet ist:
   - einer Tastatur (61) mit Tasten zur Steuerung der Dateneingabe und der Anzeigefunktion,
   - einer ersten alphanumerischen Anzeige (62), mit der die Werte des Ableitwiderstands Rf, des Störkondensators Cf und des Erdwiderstands Rt angezeigt werden können,
   - einer zweiten Balkenanzeige (64) zur kontinuierlichen Anzeige des Isolationszustands in bezug auf eine Alarmschwelle und eine Voralannschwelle,
   - einer Alarmvorrichtung (66) mit Melderelais, die bei Überschreiten der genannten Schwellen aktiviert werden,
   - und einer Kommunikationsschnittstelle (68) mit einem Datenbus (69) für die Übertragung oder den Empfang von Daten zu oder von einer externen Sende-/Empfangsvorrichtung.

9. Isolationswächter nach Anspruch 8, dadurch gekennzeichnet, daß in die Mikroprozessorsteuerung P2 eine digitale Sperre mit Geheimcode einprogrammiert ist, und daß auf der Tastatur (61) auf eine Codetaste zugegriffen werden kann, um bei Übereinstimmung des Codes die Eingabe neuer Parameter zu ermöglichen.

10. Isolationswächter nach Anspruch 8 oder 9, dadurch gekennzeichnet, daß die Tastatur (61) über eine Prüftaste verfügt, mit deren Hilfe über die Mikroprozessorsteuerung P2 ein Befehl zur Ansteuerung eines Steuerrelais (76) bereitgestellt wird, das die Aufschaltung eines Prüfwiderstands R4 und die Trennung des Treiberfilters (26) vom Netz bewirkt.

## Claims

1. An isolation monitor comprising :
   - a circuit for input of a reference AC signal between the power system and earth,
   - an electronic detection circuit supplying a measurement signal which is the image of the power system isolation, said isolation corresponding to an impedance Zd formed by a leakage resistance Rf electrically connected in parallel with a stray capacitor Cf, the capacitance of which depends on the characteristics of the power system,
   - means for discriminating the resistive and capacitive components of the measurement signal,
   - and means for computing and indicating the modules of said components to display the values of the leakage resistance Rf and of the stray capacitor Cf on display and alarm means, characterized in that the isolation monitor (10) comprises :
   - a signal processor P1 with digital processing designed to synthesize in real time a sine wave by table stored in a memory, and to send the digital values of this sine wave to a digital-to-analog converter CNA of an input channel (48) to generate the reference AC signal,
   - an acquisition channel (50) having a low-pass analog filter (56) connected by means of a sample-and-hold circuit (58) to an analog-to-digital converter CAN delivering a filtered digital measurement signal which is processed by synchronous demodulation in said processor P1, then transmitted to a microcontroller P2,
   - a dual measuring circuit of said acquisition channel comprising a first measuring circuit (38) delivering a first signal S1 representing the voltage input to the power system, and a second measuring circuit (44) supplying a second signal S2 representative of the leakage current flowing in the impedance Zd,
   - and a switching means (52) controlled by the processor P1 to input the first or the second signal to the acquisition channel (50).

2. The isolation monitor according to claim 1, characterized in that the frequency of the reference AC signal input to the power system by the input channel (48) is a sub-multiple of the power system frequency, and that the processor P1 synthesizes the sine wave by points using the formula :
$$\sin (A + b) = \sin (A) \cos (b) + \sin (b) \cos (A),$$

in which the first parameter A is scaled from 0 to 90 degrees in predetermined steps m1 equal to 90/n, and the second parameter b is scaled from 0 to m1 degrees in predetermined steps m2 equal to m1/n.

3. The isolation monitor according to claim 1 or 2, characterized in that the output of the digital-to-analog converter CNA is connected by means of a first amplifier A2 to an input filter (26) with a trap circuit (28) tuned to the frequency of the power system.

4. The isolation monitor according to claim 3, characterized in that the switching means (52) is formed by an analog multiplexer designed to accept alternately the first signal S1 from a resistance bridge R1-R2 of the first measurement circuit (38) connected to the power system, and the second signal S2 taken at the terminals of a measurement resistor R3 of the earthed second measurement circuit (44), switching of the switching means (52) being connected to the signal processor P1.

5. The isolation monitor according to claim 4, characterized in that a second variable gain amplifier A1 is connected between the multiplexer of the switching means (52) and the analog filter (56) to amplify said first and second signals S1 and S2, adjustment of the gain of the second amplifier A1 being performed by the processor P1 according to the value of the module of the filtered digital signal at the output of the analog-to-digital converter CAN.

6. The isolation monitor according to claim 5, characterized in that the processor P1 performs digital filtering eliminating the stray frequencies in the digitalized signals which are images of the voltage input and of the leakage current, followed by processing by synchronous demodulation consisting in multiplying said digitalized signals by the sine and cosine of the phase shift, and that at the end of each measurement and integration sequence, the processor P1 sends data concerning the real and imaginary parts of the voltage input and leakage current signals to the microcontroller P2 via a link (53).

7. The isolation monitor according to claim 6, characterized in that the microcontroller P2 computes in deferred time the values of the leakase resistance Rf, the stray capacitor Cf, and the earth resistance Rt located between the impedance Zd and the measurement resistor R3, following intermittent operation of the processor P1 at two different frequencies.

8. The isolation monitor according to claim 7, characterized in that the microcontroller P2 is associated with:
   - a keyboard (61) with control keys to enter the data and scroll the display,
   - a first alphanumeric read-out (62) to display the values of the leakage resistance Rf, the stray capacitor Cf, and the earth resistance Rt,
   - a second bar graph read-out (64) to give permanent indication of the isolation level with respect to alarm and pre-alarm thresholds,
   - an alarm device (66) with signalling relays supplied in the event of said thresholds being exceeded,
   - and a communication interface (68) with a bus (69) to transmit or receive data from an external transceiver device.

9. The isolation monitor according to claim 8, characterized in that digital sealing with a secret code is programmed inside the microcontroller P2, and that a code key is accessible on the keyboard (61) to enable the parameters to be modified if the code complies.

10. The isolation monitor according to claim 8 or 9, characterized in- that the keyboard (61) comprises a test key designed to send an excitation order via the microcontroller P2 to a control relay (76) arranged to connect a test resistor R4, and to disconnect the input filter (26) from the power system.

Fig 1

Fig 2